# EUROPEAN PATENT APPLICATION

(11) **EP 1 137 211 A1**
(43) Date of publication of application: **26.09.2001**
(21) Application number: 00960962.9
(22) Date of filing: 13.09.2000
(51) Int. Cl.: H04J 3/00, H04J 1/00, H04J 13/00, H04Q 7/38

(54) **RADIO TRANSMITTER/RECEIVER AND METHOD OF RADIO COMMUNICATION**

(30) Priority: 17.09.1999 JP 26360099
(71) Applicant: MATSUSHITA ELECTRIC INDUSTRIAL CO., LTD., Kadoma-shi, Osaka 571-8501 (JP)
(72) Inventor: AIZAWA, Junichi, Yokohama-shi, Kanagawa 240-0033 (JP); KATO, Osamu, Yokosuka-shi, Kanagawa 237-0066 (JP); UESUGI, Mitsuru, Yokosuka-shi, Kanagawa 238-0048 (JP); AKIYAMA, Takeshi, Sagamihara-shi, Kanagawa 229-0028 (JP)
(74) Representative: Grünecker, Kinkeldey, Stockmair & Schwanhäusser Anwaltssozietät
(86) International application number: JP0006240
(87) International publication number: WO0122634

(57) **Abstract**

Coding section 101 performs coding processing on transmission data and modulation section 102 modulates the output signal of coding section 101. Coding section 103 performs coding processing on a pilot signal, modulation section 104 performs primary modulation on the output signal of coding section 103 and spreading section 105 performs secondary modulation on the output signal of modulation section 104 by multiplying the signal by a specific spreading code. Superimposing section 106 superimposes the output signal of modulation section 102 and the spread pilot signal output from spreading section 105. Radio section 107 applies predetermined radio processing to the superimposed signal and then transmits the signal from transmission antenna 108 by time division or frequency division. This allows a radio communication system that adopts a TDMA system or FDMA system to perform radio communications at a high data rate.

## Description

### Technical Field

The present invention relates to a radio transmission/reception apparatus and radio communication method in a TDMA- or FDMA-based radio communication system.

### Background Art

In a radio communication system such as a cellular telephone and automobile telephone whose demand is increasing drastically in recent years, a base station installed for each cell assigns radio channels to a plurality of communication terminals that exist within the cell and performs radio communications simultaneously.

There are three main types of system to divide a plurality of radio channels, a TDMA (Time Division Multiple Access) system, FDMA (Frequency Division Multiple Access) system and CDMA (Code Division Multiple Access) system.

A radio communication system using a TDMA system or FDMA system (hereinafter referred to as "TDMA/FDMA system") of these types sends data with a pilot signal to be used for channel estimations and coherent detection, etc. inserted into every slot.

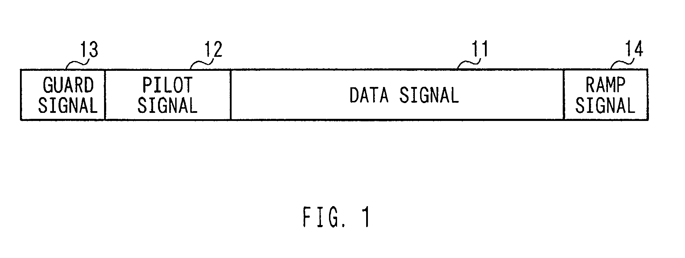

FIG.1 illustrates a slot configuration of a conventional TDMA/FDMA system. As shown in FIG.1, the conventional TDMA/FDMA system inserts a pilot signal 12 before data signal 11 that carries information.

Then, in order to prevent data signals of the nearest slots from overlapping with each other due to a propagation delay, etc. on a receiving side, a guard signal 13 is inserted before the pilot signal 12 and a ramp signal 14 is inserted after the data signal 11.

Here, overhead sections of the guard signal 13, pilot signal 12 and ramp signal 14 except data signal 11 of the signal shown in the slot configuration diagram in FIG.1 are the parts that carry no information and it is desirable to have the shortest possible overhead sections to increase a data rate.

However, the conventional TDMA/FDMA system above needs to send data with the pilot signal 12 inserted for each slot, which reduces the percentage of data signal 11 in one slot resulting in a problem of reducing the data rate.

### Disclosure of Invention

It is an object of the present invention to provide a radio transmission/reception apparatus and radio communication method in a TDMA/FDMA system capable of carrying out radio communications at a high data rate.

This object is attained by superimposing a spread pilot signal on transmission data and thereby increasing the percentage of the transmission data in one slot in the TDMA/FDMA system.

### Brief Description of Drawings

FIG.1 illustrates a slot configuration of a conventional TDMA/FDMA system;
FIG.2 is a block diagram showing a configuration of a radio transmission apparatus according to Embodiment 1 of the present invention;
FIG.3 is a block diagram showing a configuration of a radio reception apparatus according to the embodiment above;
FIG.4A illustrates a signal level before despreading according to the embodiment above;
FIG.4B illustrates a signal level after despreading according to the embodiment above;
FIG.5 illustrates a slot configuration of a superimposed signal according to the embodiment above;
FIG.6 is a block diagram showing a configuration of a radio reception apparatus according to Embodiment 2 of the present invention;
FIG.7 is a block diagram showing a configuration of a radio reception apparatus according to Embodiment 3 of the present invention; and
FIG.8 is a block diagram showing a configuration of a radio reception apparatus according to Embodiment 4 of the present invention.

### Best Mode for Carrying out the Invention

With reference now to the attached drawings, embodiments of the present invention will be explained below.

### (Embodiment 1)

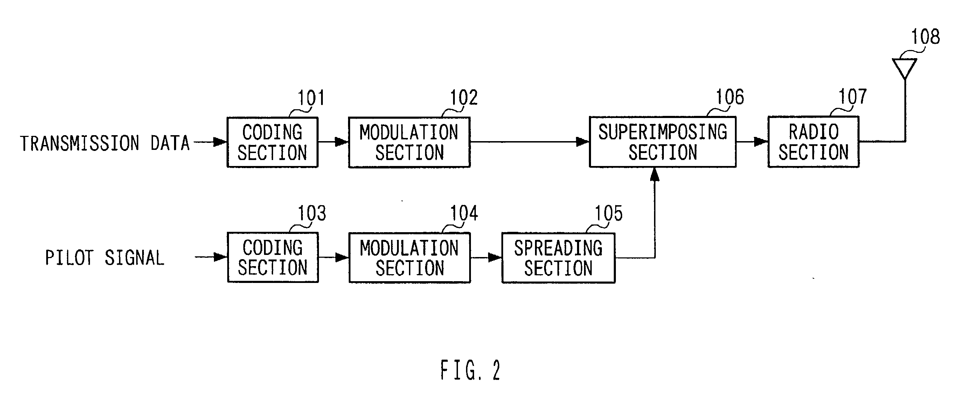

FIG.2 is a block diagram showing a configuration of a radio transmission apparatus according to Embodiment 1 of the present invention.

In the radio transmission apparatus in FIG.2, coding section 101 performs coding processing such as error correction coding on transmission data and inserts a guard signal and ramp signal. Modulation section 102 performs modulation such as QPSK on the output signal of coding section 101.

Coding section 103 performs coding processing such as error correction coding on a pilot signal. Modulation section 104 performs primary modulation such as QPSK on the output signal of coding section 103. Spreading section 105 performs secondary modulation on the output signal of modulation section 104 by multiplying the signal by a specific spreading code.

The pilot signal is spread over the entire system band or over a wide band resulting from dividing the entire system band into several portions. Hereinafter, the spread pilot signal will be referred to as a "spread pilot signal". Superimposing section 106 superimposes the spread pilot signal output from modulation section 105 on the output signal of spreading section 102. Hereinafter, the signal resulting from superimposing the spread pilot signal on the transmission data will be referred to as a "superimposed signal".

Radio section 107 applies radio processing such as amplification and frequency conversion to the superimposed signal and then transmits the signal from transmission antenna 108 by time division or frequency division.

By the way, in the explanation above, the pilot signal is totally spread and superimposed, but it is also possible not to spread some part of the pilot signal and insert that part into the transmission data and spread and superimpose the rest of the pilot signal. This is effective when a pilot signal is assigned two or more functions such as channel estimation and coherent detection.

Here, the present invention is also applicable to a case where the radio transmission apparatus has a plurality of transmission systems and transmits signals of a plurality of channels. However, in this case, simply increasing the above components according to the transmission channels will require transmission antennas corresponding in number with the transmission channels though the number of the transmission antennas is preferred to be small.

Therefore, when signals of a plurality of channels are sent, the signals are multiplexed and the multiplexed signal is sent from one transmission antenna. This makes it possible to increase a data rate and reduce the number of transmission antennas compared to the number of transmission channels.

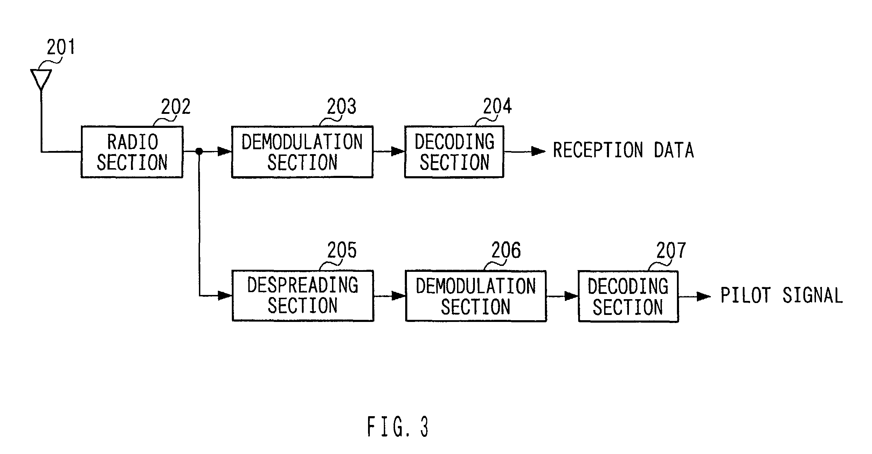

FIG.3 is a block diagram showing a configuration of the radio reception apparatus according to Embodiment 1 of the present invention.

Radio section 202 applies radio processing such as amplification and frequency conversion to the signal received by reception antenna 201.

Demodulation section 203 demodulates the output signal of radio section 202. Decoding section 204 performs decoding processing such as error correction on the output signal of demodulation section 203 and extracts reception data.

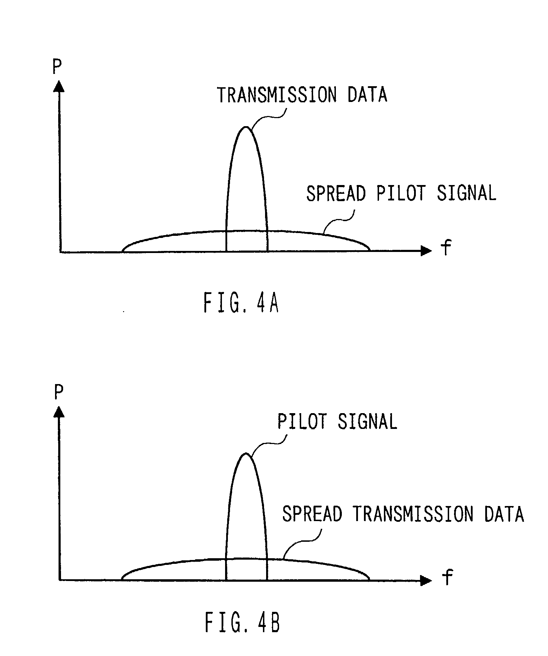

By the way, the effect of the spread pilot signal acting as an interference component on the transmission data is small. This is because since the spread pilot signal can use a processing gain as shown in FIG.4A, it is possible to reduce the level of the spreading pilot signal to a level smaller than that of the transmission data.

Despreading section 205 multiplies the output signal of radio section 202 by a same code as the spreading code multiplied by spreading section 105. Demodulation section 206 demodulates the output signal of despreading section 205. Decoding section 207 performs decoding processing such as error correction on the output signal of demodulation section 206. This makes it possible to extract the pilot signal spread and superimposed on a transmitting side.

By the way, the effect of the transmission data multiplied by a spreading code by despreading section 205 acting as an interference component on the pilot signal is small. This is because the pilot signal can obtain the gain before the spreading through the despreading processing as shown in FIG.4B, while the level of the transmission data is reduced by being multiplied by the spreading code.

Then, a signal flow between the radio transmission apparatus shown in FIG.2 and the radio reception apparatus shown in FIG.3 will be explained.

The transmission data is coded by coding section 101, modulated by modulation section 102 and sent to superimposing section 106. On the other hand, the pilot signal is coded by coding section 103, modulated by modulation section 104, spread by spreading section 105 and sent to superimposing section 106.

The spread pilot signal is superimposed on the transmission data by superimposing section 106. The output signal of superimposing section 106 is subjected to predetermined radio processing by radio section 107 and then sent from transmission antenna 108.

The signal transmitted from transmission antenna 108 is received by reception antenna 201 and subjected to predetermined radio processing by radio section 202. The output signal of radio section 202 is demodulated by demodulation section 203, decoded by decoding section 204 and reception data is extracted.

On the other hand, the output signal of radio section 202 is despread by despreading section 205, demodulated by demodulation section 206, decoded by decoding section 207 and the pilot signal is extracted.

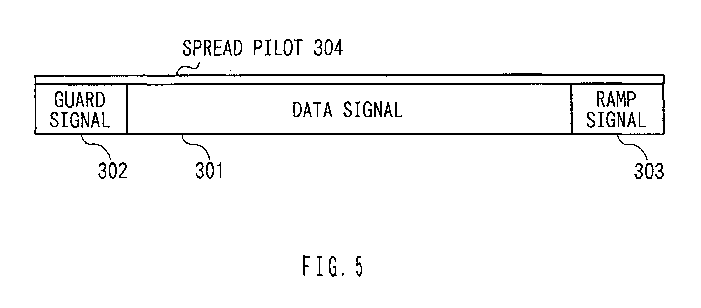

Then, a slot configuration of the superimposed signal according to this embodiment will be explained using FIG.5.

As shown in FIG.5, in the superimposed signal according to this embodiment, guard signal 302 is inserted before data signal 301, ramp signal 303 is inserted after data signal 301 and spread pilot signal 304 is superimposed over the entire slot.

In this way, sending transmission data with a pilot signal spread and superimposed on the transmission data eliminates the necessity of symbols, which are required for each conventional slot to transmit pilot signals and thereby makes it possible to increase the percentage of the data signal in one slot and increase the data rate.

### (Embodiment 2)

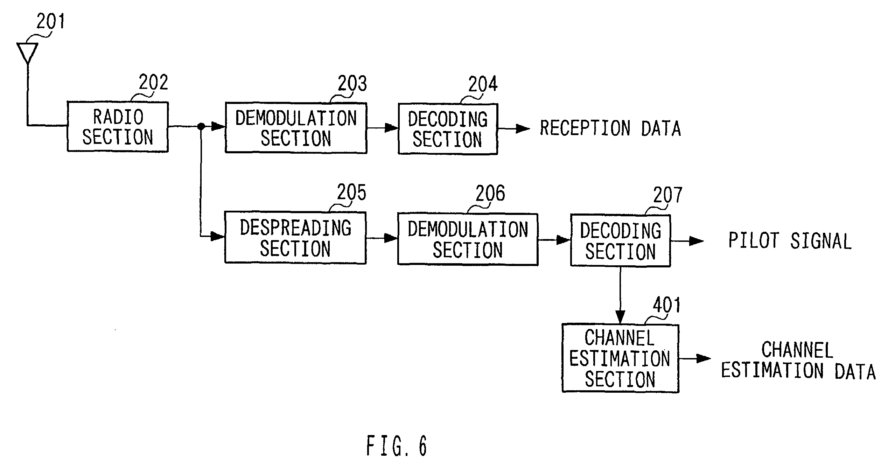

FIG.6 is a block diagram showing a configuration of a radio reception apparatus according to Embodiment 2 of the present invention. The components in FIG.6 common to those in FIG.3 are assigned the same reference numerals as those in FIG.3 and explanations thereof are omitted.

When compared to FIG.3, the radio reception apparatus shown in FIG.6 adopts a configuration with channel estimation section 401 added. Channel estimation section 401 performs a channel estimation using a pilot signal decoded by decoding section 207 and outputs channel estimation data.

While the conventional TDMA/FDMA system can only incorporate a pilot signal for each slot and can therefore perform channel estimations only intermittently, this embodiment can successively perform channel estimations using pilot signals transmitted at any time.

As a result, this embodiment can increase the frequency of updating a tap coefficient of an equalizer, etc. and improve the characteristic. Performing channel estimations is effective especially for a long slot with a slot length of 10 ms . In this case, the pilot signal must be spread over a band wide enough to correctly perform a channel estimation of the data signal within a narrow band.

### (Embodiment 3)

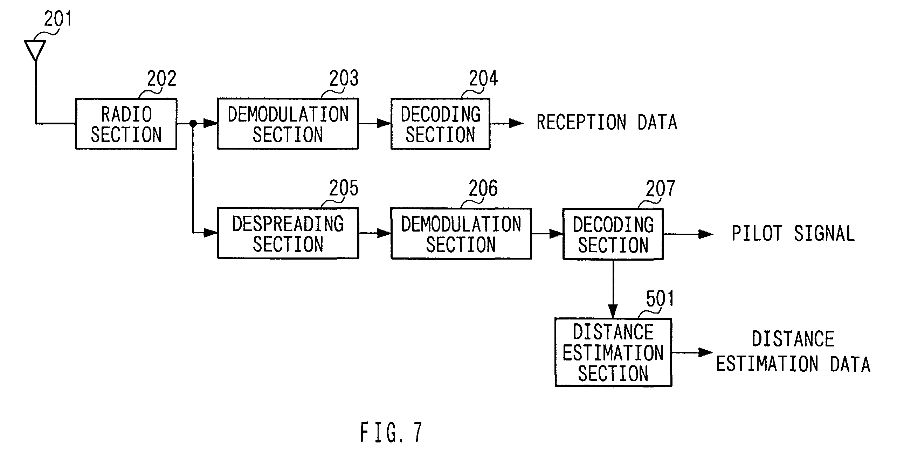

FIG.7 is a block diagram showing a configuration of a radio reception apparatus according to Embodiment 3 of the present invention. The components in FIG.7 common to those in FIG.3 are assigned the same reference numerals as those in FIG.3 and explanations thereof are omitted.

When compared to FIG.3, the radio reception apparatus shown in FIG.7 adopts a configuration with distance estimation section 501 added. Distance estimation section 501 performs a distance estimation using a pilot signal decoded by decoding section 207 and outputs distance estimation data.

This makes it possible to estimate the distance from the propagation time from the transmission to reception using the received pilot signal. Since the pilot signal is spread and sent over a wide band, it is possible to calculate the propagation time from the transmission to reception with fine time resolution and thereby improve distance estimation accuracy.

By the way, this embodiment can also be combined with Embodiment 2.

### (Embodiment 4)

As explained above, the reception quality in Embodiment 1 may slightly deteriorate compared to the conventional art due to influences of the spread pilot signal. To solve this problem, Embodiment 4 is intended to improve the reception quality by stripping the reception signal of the spread pilot signal.

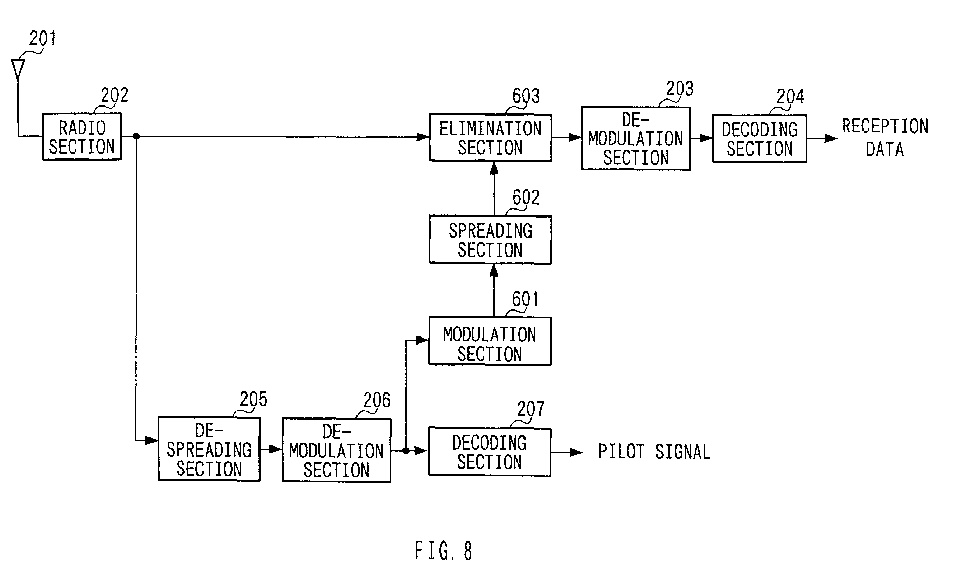

FIG.8 is a block diagram showing a configuration of a radio reception apparatus according to Embodiment 4 of the present invention. The components in FIG.8 common to those in FIG.3 are assigned the same reference numerals as those in FIG.3 and explanations thereof are omitted.

In the radio reception apparatus in FIG.8, modulation section 601 performs the same modulation processing as that in modulation section 104 on the output signal of demodulation section 206. Spreading section 602 performs the same spreading processing as that in spreading section 105 on the output signal of modulation section 601 and outputs a spread pilot signal.

Elimination section 603 inputs the spread pilot signal from spreading section 602, subtracts the spread pilot signal from the output signal of radio section 202 and thereby eliminates the spread pilot signal included in the output signal of radio section 202.

The signal output from elimination section 603 passes through a BPF (Band Pass Filter) and is demodulated in demodulation section 203, decoded by decoding section 204 and reception data is extracted.

Thus, it is possible to improve the reception quality by eliminating the spread pilot signal, which becomes interference with the data signal.

By the way, this embodiment can be combined with Embodiment 2 and Embodiment 3.

As is clear from the above explanations, the radio transmission/reception apparatus and radio communication method of the present invention can send data with a pilot signal spread and superimposed on transmission data and eliminate the necessity of a symbol which is required by a conventional TDMA/FDMA system for each slot to transmit a pilot signal, and can thereby increase the percentage of the data signal in one slot and increase the data rate.

Furthermore, by using a pilot signal extracted by despreading the reception signal, it is possible to successively perform channel estimations and improve distance estimation accuracy by calculating the propagation time from the transmission to reception with fine time resolution.

This application is based on the Japanese Patent Application No.HEI 11-263600 filed on September 17, 1999, entire content of which is expressly incorporated by reference herein.

### Industrial Applicability

The present invention is ideally applicable to a radio communication base station apparatus or radio communication terminal apparatus in a TDMA-based or FDMA-based radio communication system.

## Claims

1. A radio transmission apparatus comprising:
first spreading means for spreading a pilot signal;
superimposing means for superimposing the spread pilot signal on transmission data; and
transmitting means for transmitting the output signal of this superimposing means by time division or frequency division.

2. The radio transmission apparatus according to claim 1, wherein the transmitting means transmits a signal resulting from multiplexing signals of a plurality of channels from one transmission antenna.

3. A radio reception apparatus comprising:
receiving means for receiving a signal transmitted from the radio transmission apparatus according to claim 1; and
despreading means for extracting a pilot signal by despreading the output signal of this receiving means.

4. The radio reception apparatus according to claim 3, further comprising channel estimating means for performing a channel estimation using the pilot signal.

5. The radio reception apparatus according to claim 3, further comprising distance estimating means for performing a distance estimation using the pilot signal.

6. The radio reception apparatus according to claim 3, further comprising:
second spreading means for spreading the pilot signal output from the despreading means; and
eliminating means for subtracting the output pilot signal of said second spreading means from the output signal of the receiving means.

7. A radio communication terminal apparatus equipped with a radio transmission apparatus, said radio transmission apparatus comprising:
first spreading means for spreading a pilot signal;
superimposing means for superimposing the spread pilot signal on transmission data; and
transmitting means for transmitting the output signal of this superimposing means by time division or frequency division.

8. A radio communication terminal apparatus equipped with a radio reception apparatus, said radio reception apparatus comprising:
receiving means for receiving a signal transmitted from the radio transmission apparatus according to claim 1; and
despreading means for extracting a pilot signal by despreading the output signal of this receiving means.

9. A radio communication base station apparatus equipped with a radio transmission apparatus, said radio transmission apparatus comprising:
first spreading means for spreading a pilot signal;
superimposing means for superimposing the spread pilot signal on transmission data; and
transmitting means for transmitting the output signal of this superimposing means by time division or frequency division.

10. A radio communication base station apparatus equipped with a radio reception apparatus, said radio reception apparatus comprising:
receiving means for receiving a signal transmitted from the radio transmission apparatus according to claim 1; and
despreading means for extracting a pilot signal by despreading the output signal of this receiving means.

11. A radio communication method comprising steps of:
spreading a pilot signal, superimposing the spread pilot signal on transmission data and transmitting the superimposed signal by time division or frequency division on a transmitting side; and
despreading the reception signal and extracting the pilot signal on a receiving side.
